Europäisches Patentamt

European Patent Office

Office européen des brevets

(11) Veröffentlichungsnummer: **0 394 875**

**A1**

# (12) EUROPÄISCHE PATENTANMELDUNG

(21) Anmeldenummer: **90107563.0**

(22) Anmeldetag: **20.04.90**

(51) Int. Cl.⁵: **H05K 3/10, G03F 7/28**

(30) Priorität: **21.04.89 DE 3913115**

(43) Veröffentlichungstag der Anmeldung:
**31.10.90 Patentblatt 90/44**

(84) Benannte Vertragsstaaten:
**CH DE ES FR GB IT LI NL SE**

(71) Anmelder: **DU PONT DE NEMOURS (DEUTSCHLAND) GMBH**
**Du Pont Strasse 1**
**D-6380 Bad Homburg(DE)**

(72) Erfinder: **Dudek, Dietmar, Dr.**
**Uhlandstr. 11**
**D-6070 Langen(DE)**
Erfinder: **Pfeiffer, Thomas, Dr.**
**25 Glenbarry Drive**
**Wilmington, Delaware 198908(US)**

(54) Verfahren zur Herstellung von elektrisch leitfähigen Mustern.

(57)

2.1. Die Herstellung von Leiterbahnmustern auf keramischen Substraten nach dem Pulververfahren erfordert spezielle Pulver, welche die für die Steuerung der Haftung und des Sintervorgangs notwendigen Zusatzelemente enthalten. Die Herstellung dieser Pulver ist kompliziert ist und ihre Zusammensetzung kann sich beim Auftragen verändern. Es soll ein Verfahren angegeben werden, welches die Verwendung handelsüblicher Pulver, die nur aus den Leitmetallen bestehen, ermöglicht.

2.2. Es wird zunächst ein Pulverbild aus einem Leitmatallpulver erzeugt und auf diese in einem zweiten Auftragungsvorgang ein Pulver, welches die Zusatzelemente enthält, aufgetragen.

2.3. Herstellung gedruckter Schaltungen auf keramischen Substraten, beispielsweise für Hybridschaltkreise.

EP 0 394 875 A1

## Verfahren zur Herstellung von elektrisch leitfähigen Mustern

Die Erfindung betrifft ein Verfahren zur Herstellung von elektrisch leitfähigen Mustern auf keramischen Substraten, wie sie beispielsweise als elektrische Schaltkreise in Hybridanordnungen verwendet werden.

Aus der deutschen Auslegeschrift 11 07 743 und der kanadischen Patentschrift 11 55 967 ist bekannt, elektrisch leitfähige Muster auf der Oberfläche von keramischen Substraten nach dem sog. Pulververfahren herzustellen. Dabei wird auf der Oberfläche des Substrates ein klebriges Muster erzeugt und danach die Oberfläche mit einem Metallpulver behandelt. Durch eine Wärmebehandlung kann dann das klebrige Material entfernt und das Metallpulver zu einem zusammenhängenden Muster von Leiterbahnen gesintert werden.

Im allgemeinen ist es notwendig, daß neben dem eigentlichen Leitmetall, aus dem die Leiterbahnen gebildet werden, in dem System noch weitere Zusatzelemente, ggf. in Form geeigneter Verbindungen, zugegen sind, um die Haftung der gemusterten Metallschicht auf dem Substrat nach dem Sintern zu ermöglichen und um den Sintervorgang so zu steuern, daß Leiterbahnen mit glatter Oberfläche und gleichmäßigem Querschnitt entstehen. Man unterscheidet zwei Mechanismen für das Zustandekommen der Haftung. Bei der Glasbindung bilden die Oxide der Zusatzelemente ein Glas, welches bei der Brenntemperatur schmilzt und das Substrat mit der Leiterbahn nach dem Erkalten teils durch Adhäsion, teils durch Formschluß verbindet, während bei der reaktiven oder Oxidbindung durch Festkörperreaktion dieser Oxide mit Substrat und Leitmetall eine bindende Zwischenphase entsteht. Die Auswahl der Zusatzelemente richtet sich dementsprechend nach dem Leitmetall und nach der Art des Substrats. Geeignete Kombinationen sind aus der Dickfilmtechnik bekannt. Beispielsweise sind in der deutschen Patentschrift 25 43 922 haftvermittelnde Verbindungen für Gold und Silber auf Aluminiumoxid, Berylliumoxid und Saphir genannt, die Cadmium, Kupfer, Blei, Titan, Zirkonium, Silicium, Bor und Alkalimetalle enthalten. Es ist auch bekannt, dekorative Goldüberzüge auf keramischen Substraten durch Verbindungen von Rhodium, Wismut und Silber so zu modifizieren, daß beim Sintern gleichmäßige Schichten mit guter Haftung und glänzender Oberfläche entstehen (s. z.B. Ullmann's Enzyklopädie der technischen Chemie, 4. Auflage, Band 14, Seite 10).

Die Zusatzelemente sollen demnach ihre Wirkung hauptsächlich an der Grenzfläche zwischen Substrat und Leitmetall bzw. an der Oberfläche des Leitmetalls entfalten. Es ist im allgemeinen nachteilig, wenn sie in das Leitmetall eindringen und mit diesem Mischungen bilden, weil dadurch die spezifische Leitfähigkeit in der Leiterbahn herabgesetzt wird.

In der deutschen Patentanmeldung 38 06 515 wird ein Verfahren beschrieben, mit dem man Metallpulver für das Pulververfahren herstellen kann, welche geeignete Verbindungen der erforderlichen Zusatzelemente in homogener Verteilung enthalten. Durch Verwendung der so gewonnenen Pulver lassen sich zwar feine Leiterbahnen guter Beschaffenheit und Leitfähigkeit herstellen. Das Herstellungsverfahren für die Pulver ist jedoch relativ kompliziert. Es ist auch nachteilig, daß für verschiedenartige Substrate und je nach der angestrebten Beschaffenheit der Leiterbahnen verschiedene Metallpulver hergestellt und vorrätig gehalten werden müssen.

Die Erfindung stellt sich daher die Aufgabe, ein Verfahren anzugeben, nach dem sich auf einfache Weise die für die Herstellung von elektrisch leitfähigen Mustern auf keramischen Substraten nach dem Pulverfahren für die Steuerung der Haftung und des Sinterungsvorgangs notwendigen Zusatzelemente so in das System einbringen lassen, daß sie die Leitfähigkeit des Leitmetalls nicht beeinträchtigen.

Diese Aufgabe wird durch ein Verfahren nach dem Anspruch 1 gelöst.

Für die Erzeugung des wenigstens zeitweise klebrigen Musters auf dem Substrat kann beispielsweise ein geeigneter Klebstoff dienen, der mittels Siebdruck auf die Substratoberfläche aufgebracht wird. Wegen des höheren Auflösungsvermögens und der daraus resultierenden wesentlich höheren Feinheit der metallischen Muster wird jedoch bevorzugt eine lichtempfindliche Schicht verwendet, deren Klebrigkeit sich bei Belichtung ändert. Geeignete Verbindungen sind in den deutschen Patentschriften 12 10 321, 19 04 059, 19 44 311, 27 28 09, 28 15 894, 30 23 247, 34 29 615 und anderen beschrieben. Besonders bevorzugt als lichtempfindliche Schichtkomponenten sind 1,4-Dihydropyridinverbindungen nach der DE-PS 34 29 615.

In der DE-PS 35 40 804 wird beschrieben, daß Pulverbilder aus Leuchtpigmenten, die unter Verwendung von lichtempfindlichen 1,4-Dihydropyridinverbindungen hergestellt wurden, bei einer Behandlung mit einem zweiten Pulver verunreinigt werden können. Als Erklärung wird angegeben, daß die klebrige Fläche beim Auftragen des ersten Pigments nicht völlig mit diesem abgesättigt wird. Für Pulverbilder aus metallhaltigen Pulvern ist dies jedoch nicht zu erwarten. Die Flächenauftragsgewichte sind in diesem Fall nämlich - weil die Pulverbilder zu geschlossenen Leiterbahnen ausreichender Dicke und Leitfähigkeit gesintert werden sollen - so hoch, daß die klebrige Fläche von mindestens einer geschlossenen Schicht aus

EP 0 394 875 A1

Pulverteilchen bedeckt ist.

Unter diesen Umständen können Teilchen eines zweiten Pulvers nicht an der nicht abgesättigten klebrigen Schicht sondern allenfalls an der äußeren Fläche der metallhaltigen Pulverschicht haften. Wie diese Haftung zustandekommt, kann nicht im einzelnen erklärt werden. Es ist möglich, daß während des ersten Auftragens einige Teilchen des metallhaltigen Pulvers nicht sofort fest haften, an ihrer Oberfläche etwas klebrige Substanz aufnehmen und schließlich an der Außenseite des Pulverbildes mit nach außen gerichteter klebriger Oberfläche fixiert bleiben. An diesen Teilchen können dann bei einem zweiten Auftragsvorgang Teilchen des zweiten Pulvers haften. Denkbar ist jedoch auch, daß klebrige Substanz aus der lichtempfindlichen Schicht durch Diffusion über die Oberfläche der Teilchen des ersten Pulverbildes an die Außenseite der Pulverschicht gelangt und so das Anhaften des zweiten Pulvers ermöglicht.

Im allgemeinen wird bei der Ausführung des erfindungsgemäßen Verfahrens beobachtet, daß die Menge des beim zweiten Auftragen auf dem ersten Pulverbild abgeschiedenen zweiten Pulvers nicht nur von den Bedingungen beim zweiten Auftragen, sondern auch von denen beim ersten Auftragen und in der Zeit zwischen beiden Arbeitsgängen bestimmt wird. Durch Vorversuche kann man die für den gewünschten Auftrag notwendigen Parameter ermitteln.

Der Fachmann würde erwarten, daß Verbindungen der Zusatzelemente, wenn sie die Haftung der Leiterbahnen am Substrat sichern sollen, zwischen Leiterbahn und Substrat eingebracht werden müssen. Die Erfindung zeigt jedoch überraschenderweise, daß es möglich ist, auch durch Auftragen haftvermittelnder Verbindungen auf die Außenseite der Pulverschicht die Haftung der gesinterten Leiterbahn am Substrat sicherzustellen.

Pulver für den Aufbau des ersten Pulverbildes bestehen vorzugsweise aus den Leitmetallen ohne weitere Zusätze. Als Leitmetalle kommen bevorzugt Gold, Silber, Platin, Palladium, Kupfer und deren Legierungen untereinander in Frage. Man kann auch eine Mischung mehrerer Metallpulver für die Erzeugung des Pulverbildes verwenden.

Die Auswahl der Zusatzelemente richtet sich nach der Art der für den Aufbau der metallischen Muster verwendeten Metalle und nach der Art des Substrats. Der Fachmann kann hierzu den Stand der Technik sowie seine Erfahrungen auf dem Gebiet der Dickfilmtechnik heranziehen.

Zusatzelemente, die zur Steuerung der Haftung und des Sinterns in dem zweiten Pulver enthalten sind, können beispielsweise Wismut, Cadmium, Blei, Rhodium, Kupfer, Nickel, Bor, Aluminium und/oder Silicium sein. Die Haftung kann also sowohl nach dem Mechanismus der Oxidbindung als auch nach dem der Glasbindung eingestellt werden.

Das zweite Pulver kann die Zusatzelemente sowohl in reiner Form als auch in Form von Salzen oder Oxiden enthalten. Wenn das Leitmetall ein Edelmetall ist, kann das Sintern des Pulverbildes in oxidierender Atmosphäre erfolgen, und die in reiner Form eingebrachte Zusatzelemente werden dabei in die haftungsvermittelnden Oxide überführt. Für diese Ausgestaltung des Verfahrens eignen sich insbesondere metallisches Wismut, Cadmium, Blei, Bor und Rhodium.

Als Bestandteile des zweiten Pulvers lassen sich diese letztgenannten Elemente aber auch in Form von Oxiden oder Salzen verwenden.

Schließlich ist es möglich, als zweites Pulver ein Glaspulver anzuwenden, welches beispielsweise Oxide des Siliciums, Bleis, Aluminiums und/oder Bors enthält.

Als wärmebeständige Substrate dienen, dem derzeitigen Stand der Technik entsprechend, bevorzugt Formkörper aus Aluminiumoxid. Es können jedoch auch andere bekannte Substrate, beispielweise aus Berylliumoxid, Aluminiumnitrid, Siliciumdioxid oder emailliertem Metall, Anwendung finden.

Die keramischen Substrate mit den durch das Auftragen der Pulver auf die klebrigen Oberflächenbereiche entstandenen Pulverbildern werden in üblicher Weise gebrannt. Dabei werden die zumindest zeitweise klebrigen Schichten durch Verdampfen oder durch Oxidation entfernt und gleichzeitig die Pulverbilder zu den gewünschten Leiterbahnzügen gesintert.

Nach dem erfindungsgemäßen Verfahren hergestellte Leiterbahnmuster haben einen geringen Gehalt an Fremdmetallen und kommen daher mit ihrer spezifischen Leitfähigkeit den reinen kompakten Metallen sehr nahe. Da sie leicht mit größerer Dicke als Dünnfilmmuster erzeugt werden können, sind sie diesen in der Leitfähigkeit überlegen. Sie besitzen eine glänzende Oberfläche, sehr gleichmäßige Begrenzungslinien und zeigen auch bei Breiten unter 20 $\mu$m keine Unterbrechungen. Ihre Haftung am Substrat ist sehr stark und gleichmäßig, sodaß die Häufigkeit von Haftungsfehlern drastisch vermindert ist.

Die zur Steuerung des Sinterns und der Haftung erforderlichen Zusatzelemente können vollständig in dem zweiten Pulver enthalten sein. So ist es möglich, zum Tonen der klebrigen Muster reine Metallpulver zu verwenden, die keiner besonderen Vorbehandlung unterzogen worden sind. Da solche Pulver handelsüblich sind, wird der Prozeß gegenüber dem Stand der Technik sehr vereinfacht. In diesem Fall ergibt sich als weiterer Vorteil, daß das Tonerpulver im Verlauf des Gebrauchs in seiner Zusammensetzung konstant

3

bleibt, da es keine Komponenten enthält, die selektiv an der klebrigen Oberfläche haften könnten.

Die Erfindung wird angewendet bei der Herstellung von Leiterbahnmustern auf keramischen Substraten, beispielsweise für Hybridschaltungen. Sie kann auch für andere Zwecke, z.B. metallische Dekorationen, eingesetzt werden.

Anwendungsbeispiel:

Auf 5x5 cm große Probeplättchen aus Aluminiumoxid wurde eine Lösung aus je 3,25 g des Dimethyl- und des Diethylesters der 2,6-Dimethyl-4-(2'-nitrophenyl)-1,4-dihydropyridin-3,5-dicarbonsäure in 100 ml Methylethylketon aufgetragen und getrocknet, so daß die trockene lichtempfindliche Schicht etwa 1,5 $\mu$m dick war. Auf diese Schicht wurde mit einer Quecksilberdampflampe ein Testmuster aufbelichtet, welches Leiterbahnen von 25 $\mu$m Breite und quadratische Flächen von 2x2 mm für die Bondprüfung aufwies. Auf der belichteten Schicht wurde mit reinem Goldpulver von 1,5 $\mu$m mittlerer Teilchengröße ein Pulverbild mit einem Flächenauftragsgewicht von etwa 8 mg/cm² nach dem Verfahren der DE-PS 37 36 391 erzeugt. Nach einer Wartezeit von 5 min bei Zimmertemperatur wurden in einem zweiten Auftragsschritt folgende Pulver aufgetragen:

Probe 1: Reines Wismutmetall mit einer mittleren Teilchengröße von 10$\mu$m. Je cm² des ersten Pulverbildes blieben 0,8 mg Wismut haften.

Probe 2: Feingemahlenes Wismut-(III)-nitrat. Auftrag 0,7 mg/cm².

Probe 3: Eine Mischung aus gleichen Gewichtsteilen von Wismut- (III)-nitrat und Blei-(II)-acetat. Auftrag 0,6 mg/cm².

Probe 4: Glaspulver der Zusammensetzung (Gewichtsprozent): 17,9% Siliciumdioxid, 72,1% Bleioxid, 2,8% Aluminiumoxid, 1,2% Boroxid, Auftrag 0,2 mg/cm².

Danach wurden die Plättchen bei 900 °C 10 min gebrannt. Die mikroskopische Untersuchung der Probeplättchen zeigte Leiterbahnen mit glatten Rändern. und glatter Oberfläche.

Die Adhäsion der Goldschicht auf dem Substrat wurde bestimmt, indem 37,5 $\mu$m starke Golddrähte auf die 2x2 mm großen Flächen aufgebondet und die zum Abreißen notwendigen Kräfte bestimmt wurden. Dieser Versuch wurde etwa hundertmal wiederholt und der Mittelwert der Abreißkraft bestimmt. Für die Ermittlung des spezifischen Widerstandes der Leiterbahnen wurde deren Querschnitt aus der durch Wägung bestimmten aufgetragenen Pulvermenge berechnet. Die Prüfergebnisse sind in untenstehender Tabelle aufgeführt.

Vergleichsversuch:

Bei diesem Versuch wurden die klebrigen Muster mit einem Pulver behandelt, das aus 104 mg Wismut-(III)-acetat und 5 g Goldpulver nach dem im Beispiel 2 der deutschen Patentanmeldung 38 06 515 beschriebenen Verfahren hergestellt worden war. Es wurde kein zweites Pulver aufgetragen. Im übrigen wurde wie beim Anwendungsbeispiel gearbeitet.

Tabelle:

| Probe | Abreißkraft (cN) | Spez. Widerstand ($\mu\Omega$cm) |
|---|---|---|
| 1 | 15,8 | 2,8 |
| 2 | 13,8 | 2,6 |
| 3 | 14,7 | 2,6 |
| 4 | 16,3 | 2,6 |
| Vergleich | 16,7 | 2,8 |

Das Ausführungsbeispiel zeigt, daß mit dem wesentlich einfacheren Verfahren der Erfindung Ergebnisse gleicher Qualität wie nach dem Stand der Technik erzielt werden.

4

**Ansprüche**

1. Verfahren zur Herstellung von elektrisch leitfähigen Mustern nach dem Pulververfahren unter Verwendung einer wenigstens zeitweise klebrigen Schicht und eines metallhaltigen Pulvers, wobei das Pulverbild durch Wärmebehandlung in Gegenwart von Zusatzelementen, welche die Haftung der Leiterbahnen am Substrat und das Sinterverhalten des Leitmetalls steuern, oder von Verbindungen solcher Zusatzelemente in ein Leiterbahnmuster umgewandelt wird,
dadurch gekennzeichnet, daß
das erste Pulverbild aus dem metallhaltigen Pulver in einem zweiten Auftragsprozeß mit einem zweiten Pulver, welches solche Zusatzelemente enthält, behandelt wird.

2. Verfahren nach Anspruch 1
dadurch gekennzeichnet, daß
die wenigstens zeitweise klebrige Schicht eine lichtempfindliche Schicht ist, die durch Belichtung ihre Klebrigkeit ändert.

3. Verfahren nach Anspruch 1 oder 2,
dadurch gekennzeichnet, daß
die lichtempfindliche Schicht 1,4-Dihydropyridinverbindungen enthält.

4. Verfahren nach Anspruch 1 bis 3,
dadurch gekennzeichnet, daß
das metallhaltige Pulver nur aus Leitmetall besteht und keine Zusatzelemente enthält.

5. Verfahren nach Anspruch 1 bis 4
dadurch gekennzeichnet, daß
als Leitmetalle Gold, Silber, Platin, Palladium oder Kupfer in reiner Form oder als Mischung oder Legierung verwendet werden.

6. Verfahren nach Anspruch 1 bis 5,
dadurch gekennzeichnet, daß
die in dem zweiten Pulver enthaltenen Zusatzelemente Wismut, Cadmium, Blei, Rhodium, Kupfer, Nickel, Bor, Aluminium und/oder Silicium sind.

7. Verfahren nach Anspruch 1 bis 6,
dadurch gekennzeichnet, daß
daß das zweite Pulver aus metallischem Wismut, Cadmium, Blei, Bor und/oder Rhodium besteht.

8. Verfahren nach Anspruch 1 bis 6,
dadurch gekennzeichnet, daß
daß das zweite Pulver Oxide oder Salze des Wismuts, Cadmiums, Bleis, Bors und/oder Rhodiums enthält.

9. Verfahren nach Anspruch 1 bis 6,
dadurch gekennzeichnet, daß
das zweite Pulver ein Glaspulver ist, welches Oxide des Siliciums, Bleis, Aluminiums und/oder Bors enthält.

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 224 137 (DU PONT) <br> * Seite 2, Zeilen 10-29; Ansprüche 1,2,8,9 * <br> --- | 1-3 | H 05 K 3/10 <br> G 03 F 7/28 |
| A | EP-A-0 035 187 (DU PONT) <br> * Ansprüche 1,2 * <br> --- | 1-5 | |
| A | DE-A-3 541 427 (DU PONT) <br> * Ansprüche 1,9-11,13 * <br> --- | 1-6 | |
| A | EP-A-0 200 110 (HITACHI) <br> * Ansprüche 7-9 * <br> --- | 1-6 | |
| A,D | DE-A-3 429 615 (DU PONT) <br> * Seite 3, Zeile 13 - Seite 5, Zeile 10 * <br> --- | 1-5 | |
| A,D | CA-A-1 155 967 (NORTHERN TELECOM) <br> * Ansprüche 1-18 * <br> ----- | 1 | |

| | | | RECHERCHIERTE SACHGEBIETE (Int. Cl.5) |
|---|---|---|---|
| | | | H 05 K 3/00 <br> G 03 F 7/00 |

Der vorliegende Recherchenbericht wurde für alle Patentansprüche erstellt

| Recherchenort | Abschlußdatum der Recherche | Prüfer |
|---|---|---|
| BERLIN | 26-07-1990 | HAHN G |